# EUROPÄISCHE PATENTANMELDUNG

(11) **EP 4 489 538 A1**
(43) Veröffentlichungstag der Anmeldung: **08.01.2025**
(21) Anmeldenummer: 23183072.0
(22) Anmeldetag: 03.07.2023
(51) Int. Cl.: H05K 7/20, F28F 3/12

(54) **KÜHLSTRUKTUR UND VERFAHREN ZU DEREN HERSTELLUNG**

(71) Anmelder: HENSOLDT Sensors GmbH, 82024 Taufkirchen (DE)
(72) Erfinder: Sander, Jörg, 89075 Ulm (DE); Scheiffele, Simon, 89129 Langenau (DE); Thierer, Paul, 89233 Neu-Ulm (DE); Scheich, Dominik, 89257 Illertissen (DE)
(74) Vertreter: LifeTech IP Spies & Behrndt Patentanwälte PartG mbB

(57) **Zusammenfassung**

Eine mehrschichtige Kühlstruktur zum Kühlen einer Baugruppe (50) mittels eines Kühlmediums (70) ist offenbart. Die Kühlstruktur umfasst: eine Wärmeaufnahmeebene (110), eine Wärmeabführebene (120), eine Zuführebene (130) und eine Vielzahl Verbindungskanälen (140). Die Wärmeaufnahmeebene (110) umfasst eine Wärmeaufnahmefläche (115) und eine darauf ausgebildete Vielzahl von Kühlwannen (112), wobei die Wärmeaufnahmefläche (115) an die Baugruppe (50) koppelbar ist, um Wärme (Q) durch das Kühlmedium (70) in den Kühlwannen (112) aufzunehmen. Die Wärmeabführebene (120) bildet einen Abführkanal (125) für das Kühlmedium (70) mit der aufgenommenen Wärme (Q) und der Abführkanal (125) steht über eine Vielzahl von Abführöffnungen (127) mit der Wärmeaufnahmeebene (110) fluid in Verbindung. Die Zuführebene (130) bildet einen Zuführkanal (135) für das Kühlmedium (70) und weist eine Vielzahl von Zuführöffnungen (137) auf. Die Vielzahl von Verbindungskanälen (140) verbinden jeweils eine Zuführöffnung (137) mit jeweils einer Kühlwanne (112) fluid. Die Wärmeaufnahmeebene (110), die Wärmeabführebene (120) und die Zuführebene (130) schichtweise übereinander angeordnet sind.

## Beschreibung

Die vorliegende Erfindung bezieht sich auf eine mehrschichtige Kühlstruktur und ein Verfahren zu deren Herstellung und insbesondere auf ein Verfahren zur Herstellung einer mehrschichtigen Kühlstruktur mittels einer additiven Fertigung.

### HINTERGRUND DER ERFINDUNG

Zum Kühlen elektronischer Baugruppen wurden bereits konventionelle Kühlgeometrien entwickelt. Meist handelt es sich dabei um Systeme, in denen ein Kühlmedium (gasförmig oder flüssig) linear an eine Kühlgeometrie vorbeigeführt werden, die beispielsweise Kühlrippen oder einen sogenannte Pin-Array-Kühlkörper umfassen können.

Bei diesen Systemen wird jedoch aufgrund der geometrischen Bedingungen der Wärmeabfluss und somit der Kühleffekt durch eine stetige Aufwärmung des Kühlmediums beim Vorbeifließen an die zu kühlende Baugruppe über die Länge des Kühlerkörpers stetig reduziert, da sich das Kühlmedium stetig aufwärmt. Dies führt zu einer ungleichmäßigen bzw. unzureichenden Wärmeverteilung innerhalb der zu kühlenden Baugruppe bzw. in dem betreffenden Gehäuse. Als Folge werden die elektronischen Baugruppen bei verschiedenen Einsatz- bzw. Einbaubedingungen nur unzureichend gekühlt. Für viele Anwendungen ist das zunehmend nicht mehr hinnehmbar.

Somit besteht ein Bedarf nach weiteren Kühlstrukturen, die eine flächenmäßige Kühlung bereitstellen und darüber hinaus eine gleichförmige Kühlung auch über große Flächen sicherstellen können.

### KURZBESCHREIBUNG DER ERFINDUNG

Zumindest ein Teil der obengenannten Probleme wird durch eine mehrschichtige Kühlstruktur nach Anspruch 1 und ein Verfahren zur dessen Herstellung nach Anspruch 13 gelöst. Die abhängigen Ansprüche beziehen sich auf weitere vorteilhafte Ausgestaltungen der Gegenstände der unabhängigen Ansprüche.

Die vorliegende Erfindung bezieht sich auf eine mehrschichtige Kühlstruktur zum Kühlen einer Baugruppe mittels eines Kühlmediums. Die Kühlstruktur umfasst: eine Wärmeaufnahmeebene, eine Wärmeabführebene, eine Zuführebene und eine Vielzahl von Verbindungskanälen. Die Wärmeaufnahmeebene umfasst eine Wärmeaufnahmefläche und einer darauf ausgebildeten Vielzahl von Kühlwannen, wobei die Wärmeaufnahmefläche an die Baugruppe koppelbar ist, um Wärme durch das Kühlmedium in den Kühlwannen aufzunehmen. Die Wärmeabführebene bildet einen Abführkanal für das Kühlmedium mit der aufgenommenen Wärme. Der Abführkanal steht über eine Vielzahl von Abführöffnungen mit der Wärmeaufnahmeebene fluid in Verbindung. Die Zuführebene bildet einen Zuführkanal für das Kühlmedium und umfasst eine Vielzahl von Zuführöffnungen. Die Vielzahl Verbindungskanäle verbinden fluid jeweils eine Zuführöffnung mit jeweils einer Kühlwanne. Die Wärmeaufnahmeebene, die Wärmeabführebene und die Zuführebene sind schichtweise übereinander angeordnet.

Das Kühlmedium kann gasförmig (z.B. Luft) oder flüssig (z.B. Wasser oder ein anderes Kühlmittel) sein. Die Ebenen stellen Schichten dar, die übereinandergeschichtet sind, um eine flächige Kühlstruktur zu bilden. Die gesamte Kühlstruktur oder Teile davon können monolithisch gebildet sein, d.h. umfassen eine durchgehende Materialstruktur ohne Verbindungsschnittstellen.

Die Baugruppe kann eine elektronische Baugruppe sein (z.B. eine wärmeerzeugende Elektronik umfassen). Bei der Baugruppe kann es sich aber auch um eine Batterie (z.B. von elektrisch betriebenen Fahrzeugen) oder eine beliebige, insbesondere flächenförmige, Struktur oder ein System handeln, welches gekühlt werden soll. Es versteht, dass die mehrschichtige Kühlstruktur auch zum Erwärmen genutzt werden kann, um beispielsweise Batterien auf eine Betriebstemperatur zu bringen. Hierzu kann das Kühlmedium z.B. vorgewärmt werden. Auf wenn im Folgenden die Erfindung häufig für eine zu kühlende elektronische Baugruppe beschrieben wird, soll die Erfindung darauf nicht eingeschränkt werden, sondern für alle möglichen Baugruppen nutzbar sein, die temperiert werden sollen (abgekühlt oder erwärmt). Optional ist die Wärmeabführebene zwischen der Wärmeaufnahmeebene und der Zuführebene angeordnet ist und die Verbindungskanäle können durch die Wärmeabführebene verlaufen und die Vielzahl von Verbindungskanälen durch die Zuführebene hindurch verlaufen.

Optional sind die Verbindungskanäle senkrecht zu der Wärmeaufnahmefläche oder abgeschrägt (geneigt <90° oder >90°) dazu ausgebildet.

Optional verläuft eine Strömungsrichtung des Kühlmediums in der Wärmeabführebene und der Zuführebene zumindest abschnittsweise parallel zueinander.

Optional sind die Wärmeaufnahmeebene, die Wärmeabführebene und die Zuführebene durch eine periodische Aneinanderreihung einer Vielzahl von Kühlelementen aufgebaut (kachel- oder musterförmig). Die Kühlstruktur kann dann als eine regelmäßige flächige Kühlstruktur gebildet sein, wobei jedes Kühlelement eine oder mehr der folgenden Komponenten aufweist:
- eine Kühlwanne,
- eine Abführöffnung
- eine Zuführöffnung,
- einen Verbindungskanal.

Zumindest einige oder alle Kühlelemente weisen in einer Querschnittsebene parallel zur Wärmeaufnahmefläche eine quadratische, rechteckige, viereckige oder sechseckige Grundform auf.

Optional umfasst jedes Kühlelement (nur) einen Verbindungskanal und ein oder mehrere Abführöffnungen. Der Verbindungskanal kann in einem zentralen Bereich ausgebildet sein und Abführöffnungen können sich um den Verbindungskanal herum erstrecken (z.B. ringförmig). Der Verbindungskanal kann jedoch auch an einem Randbereich des Kühlelementes ausgebildet sein.

Optional ist jedes Kühlelement in der Wärmeaufnahmefläche rhombusförmig gebildet. In einem Zentralbereich kann auch der Verbindungskanal rhombusförmig gebildet sein und zwei gegenüberliegende Abführöffnungen trennen.

Optional umfassen die rhombusförmigen Kühlelemente zwei spitzwinklige Ecken und zwei stumpfwinklige Ecken. Die spitzwinkligen Ecken der Kühlelemente können mit den spitzwinkligen Ecken des Verbindungskanals mit einer Trennwand verbunden sein. Die ausgebildete Trennwand kann eine Abstützung der Wärmeabführebene bzw. der Verbindungskanäle auf der Wärmeaufnahmefläche bereitstellen.

Diese Ausgestaltung der Kühlelemente hat den technischen Effekt, dass damit eine additive Fertigung in Richtung der spitzwinkligen Ecken leicht möglich ist, ohne dass es zur additiven Fertigung Brückenstrukturen oder andere Hilfsgeometrien bedarf. Dies ist insbesondere immer dann möglich, wenn Wände, die schräg zur Fertigungsebene der additiven Fertigung zu fertigen sind einen Mindestwinkel von 40° aufweisen, was bei Ausführungsbeispielen stets so gewählt werden kann. Die Fertigungsebenen kann z.B. in der Horizontalen liegen.

Optional ist jede Kühlwanne durch eine umlaufende Partitionswand und einen Abschnitt der Wärmeaufnahmefläche als Boden gebildet, die mit einer benachbarten Kühlwanne fluid nicht in Verbindung steht. Der Abschnitt der Wärmeaufnahmefläche kann eine gleiche Form wie Kühlelemente aufweisen (z.B. rhombusförmig oder rechteckig). Es versteht sich, dass die Wärmeaufnahmefläche keine durchgehende Fläche zu sein braucht. Die Kühlelemente können als separate Bausteine gebildet werden, die zusammengesetzt die Kühlstruktur ergeben. Die Wärmeaufnahmefläche kann sich daher durch eine Aneinanderreihung von Kühlwannen ergeben. Die Wärmeaufnahmefläche kann jedoch auch als eine durchgängige Fläche gebildet sein und beispielsweise ein Material aufweisen, das einen Wärmetransport erleichtert.

Optional bildet jedes Kühlelement der Kühlstruktur einen einzelnen Wärmetauscher. Die Vielzahl der Kühlelemente bilden somit eine Parallelschaltung der einzelnen Wärmetauscher. Beispielsweise kann jedes Kühlelement ausgebildet sein (z.B. durch Anpassung der Größe), um eine gleiche Wärmemenge von der Wärmeaufnahmefläche aufzunehmen. Auf diese Weise ist es möglich, dass an jedem Kühlelement eine gleiche Temperaturdifferenz zwischen dem Kühlmedium und jedem Abschnitt der Baugruppe sichergestellt werden kann.

Optional sind in der Zuführebene eine Vielzahl von pyramidenförmigen Stützelemente gebildet, die eine vorbestimmte Kanalbreite oder Kanalhöhe für den Zuführkanal definieren. Die Stützelemente können optional weiter ausgebildet sein, um das Kühlmedium teilweise in die Verbindungskanäle zu leiten, um so eine vorbestimmte Menge an Kühlmedium der Wärmeaufnahmeebene bzw. der betreffenden Kühlwanne zuzuführen.

Optional weisen die einzelnen Abführöffnungen und/oder die einzelnen der Zuführöffnungen und/oder die Verbindungskanäle verschiedene Querschnittsflächen (Flächeninhalt) senkrecht zur Flussrichtung des Kühlmediums auf, um die Wärmeaufnahmefläche mit einem vorbestimmten Wärmeverteilungsprofil zu kühlen. Daher kann das durchströmende Volumen für die einzelnen Öffnungen/Kanäle unterschiedlich sein. Das vorbestimmten Wärmeverteilungsprofil kann homogen sein (d.h. überall soll eine gleiche Temperatur herrschen) oder gezielt inhomogen sein, d.h. bestimmte Regionen sollen stärker gekühlt werden als andere. Beispielsweise können jene Regionen stärker gekühlt werden, wo Bauelemente vorhanden sind, die viel Wärme erzeugen (zum Beispiel eine Leistungselektronik).

Ausführungsbeispiele beziehen sich auch auf ein Verfahren zur additiven Herstellung einer Kühlstruktur wie sie zuvor beschrieben wurde. Das Verfahren umfasst daher das Ausbilden einer Wärmeaufnahmeebene, einer Wärmeabführebene, einer Zuführebene und einer Vielzahl von Verbindungskanälen wie sie zuvor definiert wurden. Als Resultat kann entweder die gesamte Kühlstruktur oder zumindest die einzelnen Kühlelemente monolithisch durch einen Materialverbund hergestellt werden.

Optional kann aber auch jedes Kühlelement separat hergestellt werden und das Verfahren umfasst dann weiter ein Zusammensetzen der Kühlelemente, um die Kühlstruktur flächenförmig zu bilden. Das Zusammensetzen kann ein Verkleben oder Verschmelzen umfassen.

Dieses Verfahren oder zumindest Teile davon kann/können ebenfalls in Form von Anweisungen oder Befehlen in Software oder auf einem Computerprogrammprodukt implementiert oder gespeichert sein, wobei gespeicherte Anweisungen in der Lage sind, die Schritte nach dem Verfahren auszuführen, wenn das Verfahren auf einem Prozessor läuft. Daher bezieht sich die vorliegende Erfindung ebenfalls auf ein Computerprogrammprodukt oder auf ein maschinenlesbares Speichermedium mit darauf gespeichertem Software-Code (Softwareanweisungen), die ausgebildet sind, um eines der zuvor beschriebenen Verfahren auszuführen, wenn der Software-Code durch eine Verarbeitungseinheit ausgeführt wird. Die Verarbeitungseinheit kann jede Form von Computer oder Steuereinheit einer additiven Fertigungsmaschine sein, die einen entsprechenden Mikroprozessor aufweist, der einen Software-Code ausführen kann.

Ausführungsbeispiele lösen die obengenannten Probleme durch eine Kühlstruktur mit einem mehrschichtigen Aufbau, wobei das Kühlmedium in verschiedene einzelne Strömungen aufteilt wird und dann über die gesamte Kühlstruktur eine gleichmäßige Entwärmung der Baugruppe sicherstellt. Die Kühlstruktur kann vorteilhafterweise mit einer additiven Fertigungstechnologien hergestellt werden. Durch die, dem additiven Fertigungsverfahren eigenen Freiheiten können alle relevanten Dimensionen so angepasst werden, dass für jede Anwendung eine optimale Wärmeübertragungswerte und Druckverlustwerte erreicht werden kann.

Die additive Fertigung ist möglich, da alle Geometrien einen Aufbauwinkel von zumindest 40° zur Fertigungsebene oder Bauebene der additiven Fertigung aufweisen. Gemäß Ausführungsbeispielen weist die Kühlstruktur keine Flächen auf, die horizontal zur Fertigungsebene verlaufen, die ansonsten mit einer additiven Fertigung nicht ohne Weiteres gefertigt werden könnten. Mit anderen Worten: Ausführungsbeispiele nutzen Kühlgeometrien, die derart gestalten sind, dass keine zusätzlichen Stützstrukturen oder Hilfsgeometrien für das additive Fertigungsverfahren in der additiven Fertigungsmaschine aufgebaut werden müssten. Für die additive Fertigung kann insbesondere eine selektives Laserschmelzen (SLM; selective laser melting) genutzt werden.

Um Fertigungskosten zu reduzieren, können gemäß Ausführungsbeispielen Teile der Luftführung mit einem Polymerwerkstoff hergestellt werden.

### KURZBESCHREIBUNG DER FIGUREN

Ausführungsbeispiele der vorliegenden Erfindung werden in der folgenden detaillierten Beschreibung und den beiliegenden Zeichnungen dargestellt, die jedoch nicht so verstanden werden sollen, dass sie die Offenbarung auf die spezifischen Ausführungsformen einschränken, sondern lediglich der Erklärung und dem Verständnis dienen.
- Fig. 1: zeigt eine mehrschichtige Kühlstruktur zum Kühlen einer Baugruppe gemäß einem Ausführungsbeispiel der vorliegenden Erfindung.
- Fig. 2: zeigt eine Draufsicht auf die mehrschichtige Kühlstruktur aus der Fig. 1.
- Fig. 3: zeigt eine Querschnittsansicht durch die mehrschichtige Kühlstruktur aus der Fig. 2.
- Fig. 4A-4E: zeigen weitere Details von Kühlelemente, aus denen gemäß Ausführungsbeispiele die Kühlstruktur gebildet wird.
- Fig. 5A-5E: zeigen eine mehrschichtige Kühlstruktur mit schräg verlaufenden Kanälen gemäß weiteren Ausführungsbeispielen.
- Fig. 6: zeigt ein schematisches Flussdiagramm für ein Verfahren zur Herstellung der Kühlstruktur.

### DETAILLIERTE BESCHREIBUNG DER FIGUREN

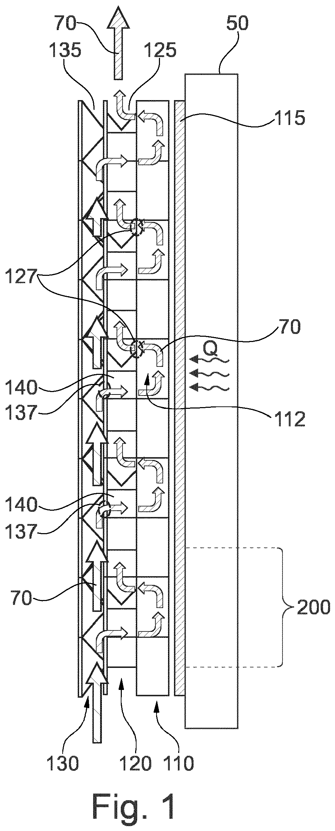

**Fig. 1** zeigt ein Ausführungsbeispiel für eine mehrschichtige Kühlstruktur zum Kühlen einer Baugruppe 50 mittels eines Kühlmediums 70. Die mehrschichtige Kühlstruktur umfasst drei Ebenen, die schichtweise übereinandergestapelt sind und eine Wärmeaufnahmeebene 110, eine Wärmeabführebene 120 und eine Zuführebene 130 umfassen. Die Wärmeaufnahmeebene 110 umfasst eine Wärmeaufnahmefläche 115 (kann als Wand ausgebildet sein), die an die Baugruppe 50 koppelt, um eine Wärme Q durch das Kühlmedium 70 von der Baugruppe 50 aufzunehmen. Die Wärmeabführebene 120 umfasst einen Abführkanal 125 zum Abführen des Kühlmediums 70. Der Abführkanal 125 kann eine verzweigte Struktur mit einer Vielzahl von Abführöffnungen 127 aufweisen, die fluid mit der Wärmeaufnahmeebene 110 verbunden sind, um das Kühlmedium 70 mit der aufgenommenen Wärme Q abzuführen. Die Zuführebene 130 umfasst einen Zuführkanal 135 zum Zuführen des Kühlmediums 70. Der Zuführkanal135 kann eine verzweigte Struktur mit einer Vielzahl von Zuführöffnungen 137 aufweisen, die fluid mit der Wärmeaufnahmeebene 110 über eine Vielzahl von Verbindungskanälen 140 fluid in Verbindung stehen, um das Kühlmedium 70 der Wärmeaufnahmeebene 110 zuzuführen.

Im Folgenden wird angenommen, dass die Baugruppe 50 eine elektronische Baugruppe ist. Wie bereits dargelegt soll die Erfindung darauf aber nicht eingeschränkt werden. Ausführungsbeispiele sollen für jede zu temperierende Baugruppe nutzbar sein.

Die Zuführöffnungen 137 sind flächenmäßig über die Kühlstruktur verteilt, um das Kühlmedium 70 an verschiedenen Stellen der Wärmeaufnahmeebene 110 zuzuführen. Damit kann die beispielhafte elektronische Baugruppe 50 homogen gleichmäßig mit dem Kühlmedium 70 gekühlt werden. Effektiv entsteht für den Fluss des Kühlmediums 70 eine Parallelschaltung von Kühlelementen 200, die parallel mit dem Kühlmedium 70 versorgt werden und die jeweils ausgebildet sind, um einen gewissen Wärmebetrag von der elektronischen Baugruppe 50 aufzunehmen und dann über die Wärmeabführebene 120 als warmes Medium 70 abzuführen.

Das Kühlmedium 70 kann beispielsweise gasförmig sein (z.B. Luft). Die vorliegende Erfindung soll jedoch nicht auf ein gasförmiges Kühlmedium 70 eingeschränkt sein. Es ist ebenfalls möglich, dass ein flüssiges Kühlmedium 70 (z.B. Wasser oder ein anderes Kühlmittel) genutzt wird, um die Wärmeaufnahmefläche 115 flächenmäßig wie gewünscht abzukühlen.

Gemäß Ausführungsbeispielen ist die Wärmeabführebene 120 zwischen der Wärmeaufnahmeebene 110 und der Zuführebene 130 ausgebildet. Dies bietet den Vorteil, dass das kalte Kühlmedium 70 in der Zuführebene 130 noch nicht in der Nähe der warmen Wärmeaufnahmefläche 115 ist. Die dazwischen angeordnete Wärmeabführebene 120 bietet somit eine gewisse thermische Isolation. Auf diese Weise kann das Kühlmedium 70 seine Temperatur behalten, während es entlang der Kühlstruktur fließt und erhitzt sich noch nicht beim Eintritt in Kühlstruktur.

Gemäß Ausführungsbeispielen werden die einzelnen Ebenen 110,120,130 der mehrschichtigen Kühlstruktur thermisch voneinander isoliert. Insbesondere kann die Zuführebene 130 von der Wärmeabführebene 120 thermisch isoliert werden, damit das Kühlmedium 70 sich nicht in der Zuführebene 130 erwärmt. Die thermische Isolierung kann beispielsweise durch eine entsprechende Materialwahl (z.B. ein Polymer) oder eine möglichst hohe Materialdicke erfolgen. Es können auch Beschichtungen an einer Zwischenwand zwischen der Zuführebene 130 und der Wärmeabführebene 120 ausgebildet werden, um den Wärmeeintrag in die Zuführebene 130 zu minimieren.

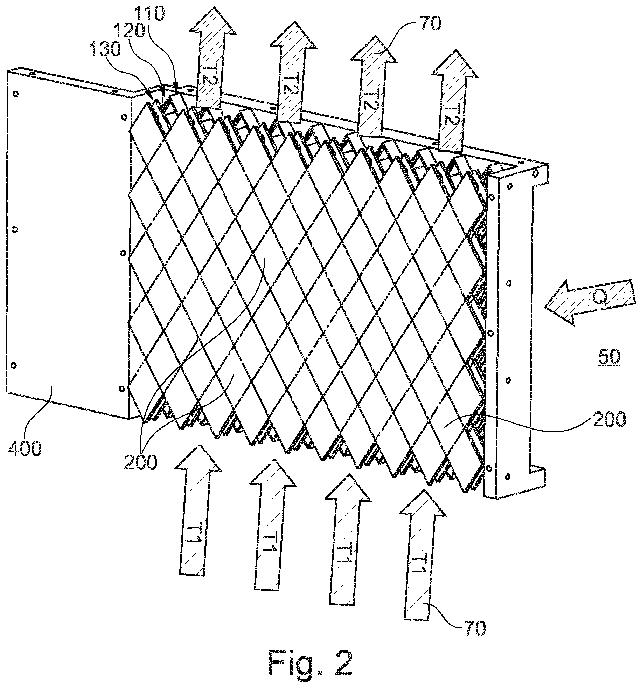

**Fig. 2** zeigt eine Draufsicht auf die mehrschichtige Kühlstruktur, wie sie flächenförmig auf einer elektronischen Baugruppe 50 platzierbar ist, um gleichmäßig Wärme Q von der elektronischen Baugruppe 50 über das Kühlmedium 70 abzuleiten. Gemäß Ausführungsbeispielen ist die mehrschichtige Kühlstruktur insbesondere kachelförmig oder regelmäßig aufgebaut und umfasst dazu eine Vielzahl von Kühlelementen 200, die beispielsweise identisch aufgebaut sein können und zusammengesetzt die flächenförmige Kühlstruktur aus der Fig. 2 zu bilden.

Das Kühlmedium 70 kann insbesondere von unten zugeführt werden, um einen vertikalen Auftrieb des aufgewärmten Kühlmediums 70 zu nutzen, um eine natürliche Konvektion des Wärmestroms entgegen der Gravitation von unten nach oben zu bewirken. Mit entsprechenden Pumpen oder Gebläsen kann die Kühlstruktur natürlich beliebig im Raum angeordnet werden.

Gemäß Ausführungsbeispielen ist die mehrschichtige Kühlstruktur in einer Vertiefung eines Halterahmens 400 eingebracht, der beispielsweise einen direkten thermischen Kontakt zu der elektronischen Baugruppe 50 herstellt und dazu beispielsweise ein sogenanntes thermisches Schnittstellenmaterial (TIM, Thermal Interface Material) aufweisen kann.

Die einzelnen Kühlelemente 200 in der Kühlstruktur können verschiedene Formen aufweisen. Insbesondere können alle Kühlelemente 200, wie in der Fig. 2 gezeigt, eine Rhombusform aufweisen, bei der die spitzen Winkel (< 90°) vertikal übereinander und die stumpfen Winkel (> 90°) horizontal nebeneinander ausgebildet sind. Die vertikale Richtung kann über die Richtung der Gravitation definiert werden. Sie gesamte Kühlstruktur kann natürlich auch gedreht werden, z.B. um 90°.

Es versteht sich, dass die Kühlelemente 200 (alle oder ein Teil) auch eine andere Form aufweisen können und die dargestellte Rhombusform lediglich ein Beispiel darstellt. So können die Kühlelemente beispielsweise als eine quadratische oder rechteckförmige Struktur oder eine sechseckförmige oder eine andere regelmäßige Gitterstruktur aufweisen, mit der sich ein flächenmäßige Kühlstruktur aufbauen lässt. Ein technischer Vorteil der gezeigten Rhombusform liegt in der dadurch möglichen einfachen Herstellung durch eine additive Fertigung. In der gezeigten Form verlaufen Ränder der gefertigten Elemente schräg noch oben - nicht aber in eine horizontale Richtung (oder schräg zur Seite), die nur schwer mit einer additiven Fertigung herstellbar sind beziehungsweise nur durch Nutzung zusätzlicher Stützelemente oder Opferstrukturen.

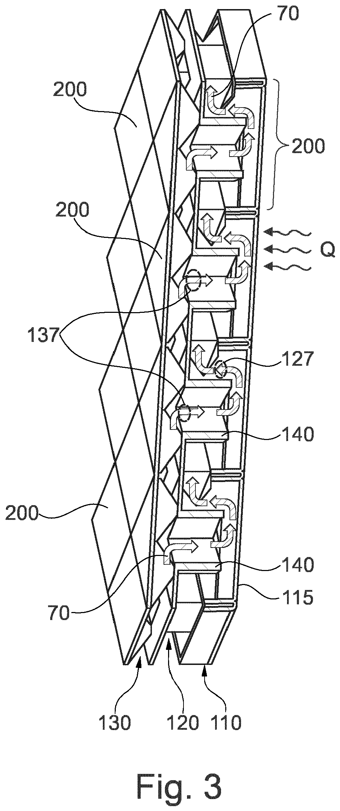

**Fig. 3** zeigt eine Draufsicht auf einen Querschnitt entlang der vertikalen Richtung durch die mehrschichtige Kühlstruktur aus der Fig. 2. Das Kühlmedium 70 strömt wiederum von unten in die mehrschichtige Kühlstruktur in die Zuführebene 130 ein. Von der Zuführebene 130 wird das Kühlmedium 70 über die Vielzahl von Zuführöffnungen 137 in eine Vielzahl von Verbindungskanälen 140 geleitet, die in die Wärmeaufnahmeebene 110 führen. Dort nimmt das Kühlmedium 70 die Wärme Q von der elektronischen Baugruppe (in der Fig. 3 nicht dargestellt) auf, um daran anschließend von der Wärmeaufnahmeebene 110 über die Abführöffnungen 127 als aufgewärmtes Kühlmedium 70 über die Wärmeabführebene 120 abgeführt zu werden.

Beispielsweise kann jedes Kühlelement 200 gleich aufgebaut sein und jeweils in einem zentralen Bereich einen Verbindungskanal 140 aufweisen, um den herum eine oder mehrere Abführöffnungen 127 gebildet sind.

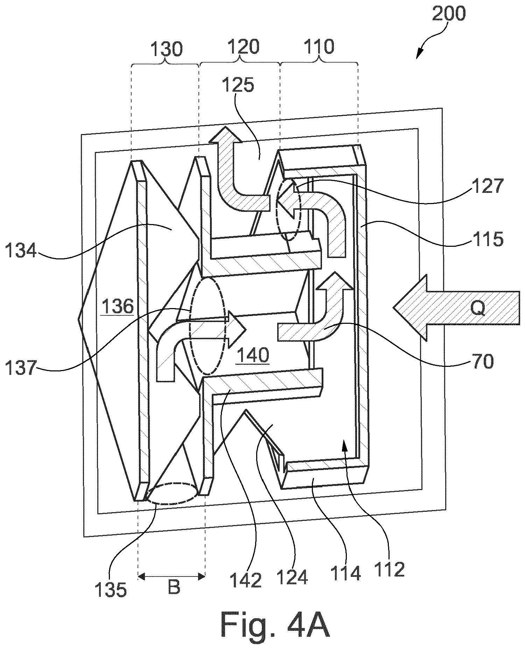

**Fign. 4A bis 4E** zeigen weitere Details der einzelnen Kühlelemente 200, die wie gesagt alle gleich aufgebaut sein können und durch Aneinanderreihung die schichtenförmige Kühlstruktur bilden.

**Fig. 4A** zeigt eine Querschnittsansicht entlang der vertikalen Richtung eines beispielhaft rhombenförmig ausgebildeten Kühlelementes 200. Das Kühlelement 200 stellt daher einen Abschnitt der Wärmeaufnahmeebene 110, einen Abschnitt der Wärmeabführebene 120 und einen Abschnitt der Zuführebene 130 dar, wobei das Kühlmedium 70 von unten über die Zuführebene 130 zugeführt wird.

Das Kühlelement 200 umfasst in einem zentralen Bereich des Rhombus die Zuführöffnung 137, die in einen viereckförmigen Verbindungskanal 140 mit den Seitenwänden 142 führt. Das Kühlmedium 70 wird so zu der Wärmeaufnahmeebene 110 geleitet.

In der Wärmeaufnahmeebene 110 ist eine Kühlwanne 112 durch Partitionswände 114 auf der Wärmeaufnahmefläche 115 gebildet, in der sich das Kühlmedium 70 sammelt oder eingeleitet wird. Die Wärmeaufnahmefläche 115, bzw. ein Abschnitt davon, bildet den Boden der Kühlwanne 112 und die Höhe der Partitionswände 114 definiert eine Schichtdicke der Wärmeaufnahmeebene 110. Nachdem das Kühlmedium 70 in der Kühlwanne 112 die Wärme Q oder ein Teil davon über die Wärmeaufnahmefläche 115 aufgenommen hat, strömt das Kühlmedium 70 über die Abführöffnungen 127 in die Wärmeabführebene 120, von wo das aufgewärmte Kühlmedium 70 abtransportiert wird.

Gemäß weiteren Ausführungsbeispielen umfasst die Zuführebene 130 Stützstrukturen 134, die beispielsweise als pyramidenförmige Stützelemente 134 ausgebildet sein können und die eine Außenfläche 136 von einer Zwischenebene zwischen der Zuführebene 130 und der Wärmeabführebene 120 abstützen. Die Stützstrukturen 134 können insbesondere dort ausgebildet sein, wo das Kühlmedium 70 in die Verbindungskanäle 140 geleitet werden soll, sodass ein Teil des Kühlmediums 70 durch die pyramidenförmige Stützelemente 134 in die Verbindungskanäle 140 geleitet wird. An den Stellen, wo keine Verbindungskanäle 140 ausgebildet sind, kann das Kühlmedium 70 an den Stützstrukturen vorbeiströmen. Der Strom des Kühlmediums 70 in dem Zuführkanal 135 bezweigt sich somit mehrfach in der Zuführebene 130.

Die pyramidenförmige Stützelemente 134 bieten daher den technischen Effekt, dass damit einerseits eine Dosierung der Menge an Kühlmedium 70, die einer bestimmten Kühlwanne 112 zugeführt werden soll, vorgenommen werden kann. So kann durch eine Platzierung der pyramidenförmigen Stützelemente 134 eine Menge an Kühlmedium 70 eingestellt werden, die in den betreffenden Verbindungskanal 140 eingeleitet wird. Anderseits können die pyramidenförmigen Stützstrukturen 134 in der additiven Fertigung leicht hergestellt werden, da sie keine horizontalen Ebenen definieren. Ebenso definieren die Stützelemente 134 die Kanalbreite B (oder Höhe) des Zuführkanals 135.

Gemäß weiteren Ausführungsbeispielen können die einzelnen Abführöffnungen 127 und/oder die einzelnen der Zuführöffnungen 137 und/oder die Verbindungskanäle 140 für die einzelnen Kühlelemente 200 verschiedene Querschnittsflächen senkrecht zur Flussrichtung des Kühlmediums 70 aufweisen, um eine selektive Dosierung des Kühlmediums 70 zu erreichen. Die Wärmeaufnahmefläche 115 kann so mit einem vorbestimmten Wärmeverteilungsprofil gekühlt werden. Es können also ganz gezielt bestimmte Bereiche der elektronischen Baugrube stärker kühlt werden als andere Bereiche. Dies wird durch die selektive Dosierung des Kühlmediums 70 - wie zuvor beschrieben - erreicht.

Gemäß Ausführungsbeispielen ist die Kühlwanne 112 für ein Kühlelement 200 über Trennwände 124 in zwei oder mehr Abschnitte partitioniert, sodass ein Teil des Kühlmediums 70 von dem Verbindungskanal 140 in den Abschnitt diesseits der Trennwand 124 in der Fig. 4A und ein weiterer Teil jenseits der Trennwand 124 (in der Zeichenebene dahinter) in die Kühlwanne 112 fließt. Diese Trennwände 124 dienen der verbesserten Stabilität der Struktur. Beispielsweise bieten sie eine Abstützung des Verbindungskanals 140 zu der Wärmeaufnahmefläche 115.

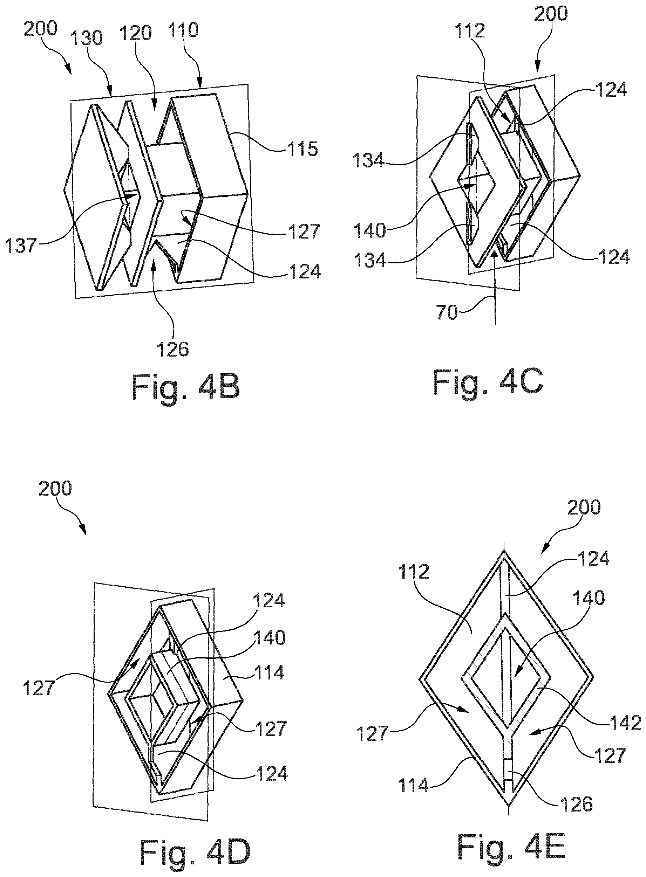

**Fig. 4B** zeigt eine Raumansicht der in der Fig. 4A dargestellten Querschnittsansicht eines Kühlelementes 200. Die Zuführebene 130 ist über zwei pyramidenförmige Stützelemente 134 auf eine Trennwand zwischen der Zuführebene 120 und der Wärmeabführebene 120 abgestützt. Zwischen den beiden Stützelementen 134 ist eine Zuführöffnung 137 ausgebildet. Außerdem ist die partitionierte Kühlwanne 112 mit den Partitionswänden 114 und dem Boden 115 rhombenförmig ausgebildet. Der ebenfalls rhombenförmig ausgebildete Verbindungskanal 140 erstreckt sich von Zuführöffnung 137 in die Kühlwanne 112 hinein, um das Kühlmedium 70 in die Kühlwanne 112 einzuleiten.

Entlang der Stromrichtung des Kühlmediums 70 ist die Trennwand 124 stromaufwärts höher ausgebildet, beispielsweise bis zu der Trennwand zwischen der Wärmeabführebene 120 und der Zuführebene 130. Dies dient vor allem der Stabilität der gesamten Kühlstruktur. In dem dort ausgebildeten Abschnitt der Trennwand 124 ist ein Ausschnitt 126 vorhanden, der eine Verteilung des Kühlmediums 70 erleichtert. Das Kühlmedium 70 kann auch in horizontaler Richtung dort strömen.

**Fig. 4C** zeigt eine Raumansicht der Wärmeabführebene 120 und der Wärmeaufnahmeebene 110, d.h. die Zuführebene 130 wurde zumindest teilweise entfernt. Die pyramidenförmigen Stützstrukturen 134 sind nur noch teilweise zu sehen. Aus der Figur ist ersichtlich, dass innerhalb der Kühlwanne 112 die Trennwände 124 unsymmetrisch ausgebildet sind, d.h. stromabwärts ist die Trennwand 124 mit einer geringeren Höhe ausgebildet als stromaufwärts (bzgl. des Stroms des Kühlmediums 70). Damit wird ein Abfluss des aufgewärmten Kühlmediums 70 erleichtert. Andererseits soll dadurch ein gezieltes Einleiten des Kühlmediums 70 in die Kühlwanne 112 unterstützt werden.

**Fig. 4D** zeigt eine Raumansicht eines Querschnitts senkrecht zur Strömungsrichtung durch den Verbindungskanal 140 für das beispielhafte Kühlelement 200. Es handelt sich wiederum um ein Ausführungsbeispiel, bei dem das Kühlelement 200 rhombenförmig ausgebildet ist. Ebenso ist der Verbindungskanal 140 rhombenförmig ausgebildet und erstreckt sich in einem zentralen Bereich des rhombenförmig gebildeten Kühlelementes 200. Die Querschnittsansicht ist in der Wärmeabführebene 120 gebildet. Aus der Darstellung ist ebenfalls ersichtlich, dass der Verbindungskanal 140 beispielhaft vollumfänglich von zwei Abführöffnungen 127 umschlossen ist.

**Fig. 4E** zeigt eine Querschnittsansicht senkrecht zur Strömungsrichtung der Kühlmediums 70, wobei das Kühlelement 200 als auch der Verbindungskanal 140 rhombenförmig gebildet sind. Zwischen den Seitenwänden 142 des Verbindungskanals 140 und den Partitionswänden 114 der Kühlwanne 112 ist somit ein konstanter Abstand gebildet, der die beiden Abführöffnungen 127 bildet. Die Trennwand 124 teilt den Verbindungskanal 140 und die Kühlwanne 112 in zwei Teile auf, in die das Kühlmedium 70 separat einströmt. Ebenso ist die Trennwand 124 stromaufwärts (unten) wieder höher ausgebildet und weist den Ausschnitt 126 als Abschrägung auf.

Gemäß Ausführungsbeispielen ist der Winkel der rhombenförmigen Kühlelemente 200 zwischen der Horizontalen und den Partitionswände 114 größer als 40° (oder größer als 60°). Dies hat den technischen Effekt, dass auf diese Art und Weise das Kühlelement 200 (oder die gesamte Kühlstruktur) durch eine additive Fertigung entlang der vertikalen Richtung gefertigt werden kann. Die horizontale Ebene kann somit die Fertigungsebene darstellen.

Gemäß Ausführungsbeispielen kann jedes Kühlelement 200 einzeln additiv gefertigt werden. Die Gesamtheit aller Kühlelement 200 kann dann flexible zu der Kühlstruktur zusammengesetzt werden (z.B. durch Verkleben oder Verschweißen). Gemäß weiteren Ausführungsbeispielen kann ebenfalls die gesamte Kühlstruktur in als Ganzes in einer Fertigungsmaschine additiv hergestellt werden.

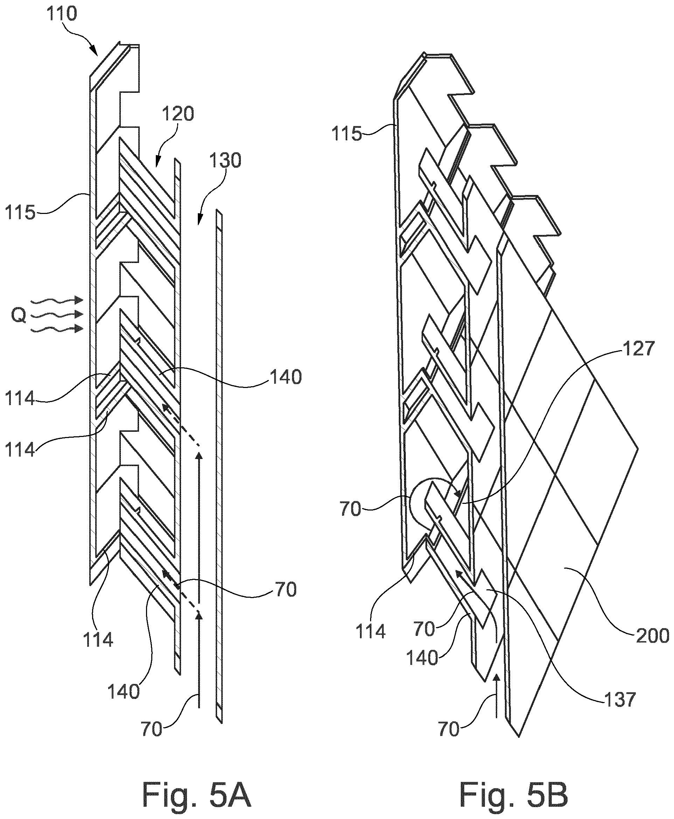

**Fign. 5A-5E** zeigen die mehrschichtige Kühlstruktur gemäß einem weiteren Ausführungsbeispiel, bei dem die Verbindungskanäle 140, die Partitionswände 114 und Trennwände 124 nicht entlang der horizontalen Richtung ausgebildet sind, sondern schräg verlaufen.

**Fig. 5A** zeigt eine Querschnittsansicht entlang der Vertikalen (wie in Fig. 1), wobei jetzt die Wärmeaufnahmefläche 115 hier auf der linken Seite angeordnet ist. Das Kühlmedium 70 soll wiederum vertikal von unten einströmen, so dass die schräg verlaufenden Verbindungskanäle 140 das Kühlmedium 70 schräg nach oben in die Kühlwannen 112 leiten. Die Partitionswände 114 der Kühlwannen 112 sind ebenfalls schräg ausgebildet, d.h. stehen nicht senkrecht auf der Wärmeaufnahmefläche 115. In den somit schräg ausgebildeten Kühlwannen 112 wird wiederum die Wärme Q durch das Kühlmedium 70 aufgenommen und anschließend über die Wärmeabführebene 120 abgeleitet.

Ein Vorteil dieser abgeschrägten Ausgestaltung der Kühlstruktur besteht darin, dass die additive Fertigung dadurch erleichtert wird, da von einer Fertigungsebene der additiven Fertigung schräg nach oben verlaufenden Strukturen problemlos gefertigt werden können. Außerdem kann das Kühlmedium 70 leichter in die schrägen Verbindungskanäle 140 mit einer nur kleinen Richtungsänderung einströmen.

**Fig. 5B** zeigt eine Raumansicht auf die Querschnittsansicht aus der Fig. 5A. Bei dieser Ausführungsform sind die Kühlelemente 200 quadratisch oder rechteckförmig ausgebildet. Die Verbindungskanäle 140 sind wiederum schräg nach oben ausgebildet (ausgehend von der Zuführebene 130). Damit kann das Kühlmediums 70 fortlaufend nach oben strömen, was den Strömungswiderstand aufgrund des thermischen Auftriebes verringert. Um eine fortlaufende vertikaler Strömung des Kühlmediums 70 zu erreichen, sind gemäß diesem Ausführungsbeispiel die Verbindungskanäle 140 direkt an einem unteren Abschnitt an einer Positionswand 114 ausgebildet. Die Verbindungskanäle 140 grenzen somit jeweils an eine Partitionswand 114. In der Querschnittsansicht der Fig. 4E würde dies dem Fall entsprechen, dass der Verbindungskanal 140 vertikal so weit nach unten verschoben wird, dass er die Partitionswände 114 berührt. Es handelt sich somit nicht mehr um eine mittige Anordnung des Verbindungskanals 140 in der jeweiligen Kühlwanne 112.

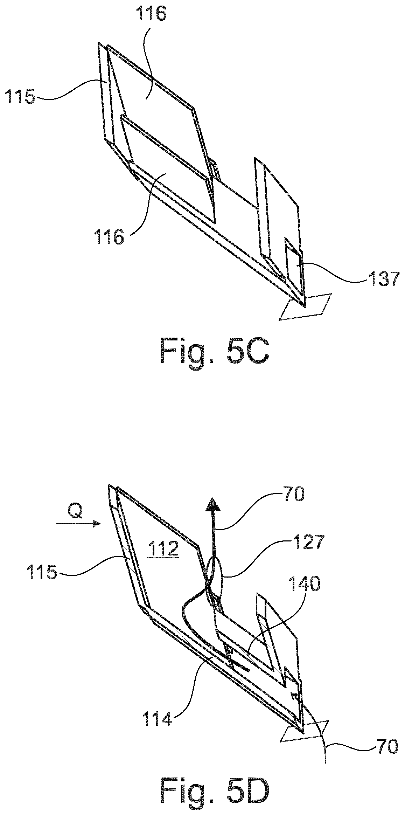

**Fig. 5C** zeigt eine Raumansicht eines Innenraums der Wärmeaufnahmeebene 110, wo gemäß weiteren Ausführungsbeispielen Kühlstrukturen 116 angeordnet sind. Die Kühlstrukturen 116 sind ausgebildet, um die Wärmeaufnahme von der Wärmeaufnahmefläche 115 zu erleichtern. Hierzu können die Kühlstrukturen 116 beispielsweise Kühlrippen, Kühlstäbe (pins) oder andere Elemente umfassen, die eine Oberfläche zur Aufnahme von der Wärme Q vergrößern und eine gute Wärmeleitfähigkeit aufweisen. Innerhalb des Kühlvolumens können diese eingebrachten Strukturen eine Maximierung der wärmeübergebenden Fläche bewirken und/oder zusätzliche Verwirbelungen erzeugen, um den Wärmeaustausch zu verbessern.

**Fig. 5D** veranschaulicht die Ausbildung des Verbindungskanals 140 direkt an einer Partitionswand 114 der Kühlwanne 112 in dem Kühlelement 200. Ein Vorteil dieser Ausgestaltung besteht - wie bereits gesagt - darin, dass der Kühlmittelstrom 70 fortlaufend vertikal nach oben erfolgen kann.

Da bei dieser Ausgestaltung alle Elemente des Kühlelementes 200 einen Winkel zur horizontalen Ebene (Fertigungsebene) von zumindest 40° aufweisen, kann eine solche Struktur problemlos mit einer additiven Fertigung, wie beispielsweise ein selektives Laserschmelzen (SLM) oder selektives Lasersinter (SLS)-Verfahren, zuverlässig gefertigt werden.

Bei der Additiven Fertigung ist es außerdem problemlos möglich, dass die Geometrien der Verbindungskanäle 140 oder der Zuführöffnungen 137 oder der Abführöffnungen 127 sich von Kühlelement oder in eine bestimmte Richtung unterscheiden können, sodass eine adaptive Kühlung gewährleistet werden kann. So können wiederum bestimmte Regionen der Wärmeaufnahmefläche 115 stärker gekühlt werden als andere Regionen, weil dort evtl. besonders viel Wärme erzeugt wird. Ebenso kann aber auch eine sehr homogene Kühlung entlang der vollständigen Wärmeaufnahmefläche 115 sichergestellt werden, weil beispielsweise vertikal weiter unten liegende Kühlelemente 200 weniger Kühlmedium 70 brauchen als vertikal weiter oben liegende Kühlelemente 200.

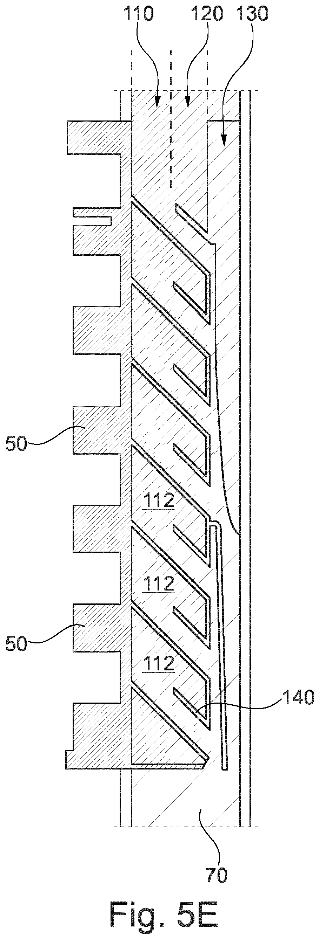

**Fig. 5E** veranschaulicht den Wärmestrom beim Einfließen des Kühlmediums 70. Beispielsweise kann bei jedem Bauelemente 50 aus der elektronischen Baugruppen eine Kühlwanne 112 vorgesehen sein, um dort eine ausreichende Kühlung sicherzustellen. Da sich das Kühlmedium 70 entlang der Zuführebene 130 bereits leicht erwärmen kann, können die Verbindungskanäle 140 bzw. die Zuführebene 130 derart gebildet werden, dass trotzdem sichergestellt ist, dass die elektronischen Bauteile 50, die vertikal weiter oben angeordnet sind, immer noch ausreichend gekühlt werden. Beispielsweise können den vertikal weiter oben liegenden Verbindungskanäle 140 eine größere Kühlmenge zur Verfügung gestellt werden als den vertikal weiter unten liegenden Verbindungskanäle 140. Ebenso kann sich die Zuführebene 130 vertikal nach oben verjüngen, um allen Kühlwannen 112 eine gewünschte Menge (gleich oder ungleich) an Kühlmedium 70 zur Verfügung zu stellen.

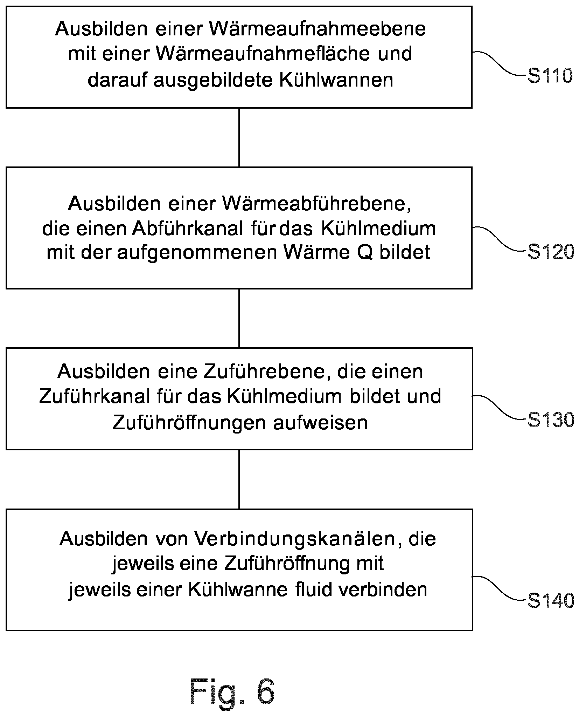

**Fig. 6** zeigt ein schematisches Flussdiagramm für ein Verfahren zur Herstellung der Kühlstruktur wie sie zuvor beschrieben wurde. Das Verfahren umfasst zumindest die folgenden Schritte:
- Ausbilden einer Wärmeaufnahmeebene S110 mit einer Wärmeaufnahmefläche 115 und einer darauf ausgebildeten Vielzahl von Kühlwannen 112, wobei die Wärmeaufnahmefläche 115 an die elektronische Baugruppe 50 koppelbar ist, um Wärme Q durch das Kühlmedium 70 in den Kühlwannen 112 aufzunehmen;
- Ausbilden einer Wärmeabführebene S120, die einen Abführkanal 125 für das Kühlmedium 70 mit der aufgenommenen Wärme Q bildet und der Abführkanal 125 über eine Vielzahl von Abführöffnungen 127 mit der Wärmeaufnahmeebene 110 fluid in Verbindung steht;
- Ausbilden eine Zuführebene S130, die einen Zuführkanal 135 für das Kühlmedium 70 bildet und eine Vielzahl von Zuführöffnungen 137 aufweist; und
- Ausbilden eine Vielzahl von Verbindungskanälen S140, die jeweils eine Zuführöffnung 137 mit jeweils einer Kühlwanne 112 fluid verbinden.

Die Wärmeaufnahmeebene 110, die Wärmeabführebene 120 und die Zuführebene 130 sind schichtweise übereinander angeordnet sind.

Optional wird dieses Verfahren mittels einer additiven Fertigung ausgeführt, wobei die Schritte des Ausbildens in Abhängigkeit der Fertigungsrichtung parallel oder in verschiedenen Reihenfolgen ausgeführt werden können.

Dieses Verfahren oder zumindest Teile davon kann/können ebenfalls in Form von Anweisungen oder Befehlen in Software oder auf einem Computerprogrammprodukt implementiert oder gespeichert sein, wobei gespeicherte Anweisungen in der Lage sind, die Schritte nach dem Verfahren auszuführen, wenn das Verfahren auf einem Prozessor läuft, z.B. einer Steuereinheit eine additiven Fertigungsmaschine.

Ausführungsbeispiele liefern die folgenden Vorteile:
- Es können sehr große wärmeübergebene Oberfläche (Wärmeaufnahmefläche) erreicht werden.
- Die Kühlstruktur bzw. jedes Kühlelement wird in größtmöglicher Weise mit der abzuführenden Wärmemenge gesättigt, da das Kühlmedium an verschiedenen Stellen mit der wärmeübergebenden Oberfläche in Kontakt kommt.
- Durch den parallelen Aufbau der Wärmeübergabebereiche (der Kühlelemente) entlang des Kühlmittelflusses ist eine nahezu beliebige Skalierung der Wärmeaufnahmefläche möglich. Es können sehr große Kühlgeometrien hergestellt werden.
- Die große Wärmeaufnahmefläche kann gleichförmig über die gesamte Fläche gekühlt werden.
- Die zur Verfügung stehenden Volumina das Kühlmediums können sehr nahe am theoretischen Maximum der Wärmesättigung bewegt werden.

Ausführungsbeispiele ermöglichen ein seitlich gekühltes Elektronikgehäuse und können beispielsweise für sogenannte ARINC-Boxen (ARINC; Aeronautical Radio INCorporated) eingesetzt werden, die im konventionellen Design von Kühlstrukturen (basierend auf gefrästen Rippen) bereits an ihre Leistungsgrenzen gelangt sind. Ausführungsbeispiele überwinden diese Leistungsgrenzen der konventionellen Rippen-Strukturen und können in zukünftigen Systemen mit höheren Verlustleistungen in vielfältigen Einsatzszenarien betrieben werden (z.B. bei einer sehr hohen Außentemperatur von jenseits von 50°C).

Ausführungsbeispiele können ebenfalls als ein reiner Luftwärmetauscher genutzt werden, sie können aber auch für gasförmig/gasförmig-Wärmetauscher oder als gasförmig/flüssig-Wärmetauscher genutzt werden.

Die in der Beschreibung, den Ansprüchen und den Figuren offenbarten Merkmale der Erfindung können sowohl einzeln als auch in beliebiger Kombination für die Verwirklichung der Erfindung wesentlich sein.

### BEZUGSZEICHENLISTE

- 50: Baugruppe (Elektronik oder Batterie)
- 70: Kühlmedium
- 110: Wärmeaufnahmeebene
- 112: Kühlwannen
- 114: Partitionswände
- 115: Wärmeaufnahmefläche
- 116: Kühlstruktur
- 120: Wärmeabführebene
- 124: Trennwände
- 125: Abführkanal
- 126: Ausschnitt in Trennwand
- 127: Abführöffnungen
- 130: Zuführebene
- 134: Stützstruktur
- 135: Zuführkanal
- 136: Außenfläche der Zuführebene
- 137: Zuführöffnungen
- 140: Verbindungskanäle
- 142: umlaufende Seitenwände
- 200: Kühlelemente
- 400: Halterahmen
- Q: (aufgenommene) Wärme
- B: Kanalbreite des Zuführkanals (der Zuführebene)

## Patentansprüche

1. Eine mehrschichtige Kühlstruktur zum Kühlen einer Baugruppe (50) mittels eines Kühlmediums (70), mit folgenden Merkmalen:
eine Wärmeaufnahmeebene (110) mit einer Wärmeaufnahmefläche (115) und einer darauf ausgebildeten Vielzahl von Kühlwannen (112), wobei die Wärmeaufnahmefläche (115) an die Baugruppe (50) koppelbar ist, um Wärme (Q) durch das Kühlmedium (70) in den Kühlwannen (112) aufzunehmen;
eine Wärmeabführebene (120), die einen Abführkanal (125) für das Kühlmedium (70) mit der aufgenommenen Wärme (Q) bildet und der Abführkanal (125) über eine Vielzahl von Abführöffnungen (127) mit der Wärmeaufnahmeebene (110) fluid in Verbindung steht;
eine Zuführebene (130), die einen Zuführkanal (135) für das Kühlmedium (70) bildet und eine Vielzahl von Zuführöffnungen (137) aufweist; und
eine Vielzahl von Verbindungskanälen (140), die jeweils eine Zuführöffnung (137) mit jeweils einer Kühlwanne (112) fluid verbinden,
wobei die Wärmeaufnahmeebene (110), die Wärmeabführebene (120) und die Zuführebene (130) schichtweise übereinander angeordnet sind.

2. Die Kühlstruktur nach Anspruch 1, wobei die Wärmeabführebene (120) zwischen der Wärmeaufnahmeebene (110) und der Zuführebene (130) angeordnet ist und die Vielzahl von Verbindungskanälen (140) sich durch die Wärmeabführebene (120) hindurch erstrecken.

3. Die Kühlstruktur nach Anspruch 1 oder Anspruch 2, wobei die Verbindungskanäle (140) senkrecht zu der Wärmeaufnahmefläche (115) oder abgeschrägt dazu ausgebildet sind.

4. Die Kühlstruktur nach einem der vorhergehenden Ansprüche, wobei eine Strömungsrichtung des Kühlmediums (70) in der Wärmeabführebene (120) und der Zuführebene (130) zumindest abschnittsweise parallel verläuft.

5. Die Kühlstruktur nach einem der vorhergehenden Ansprüche, wobei die Wärmeaufnahmeebene (110), die Wärmeabführebene (120) und die Zuführebene (130) durch eine periodische Aneinanderreihung einer Vielzahl von Kühlelementen (200) aufgebaut sind, sodass die Kühlstruktur eine regelmäßige flächige Kühlstruktur bildet, wobei jedes Kühlelement (200) zumindest eine der folgenden Komponente aufweist:
- eine Kühlwanne (112),
- eine Abführöffnung (127)
- einen Zuführöffnung (137),
- einen Verbindungskanal (140).

6. Die Kühlstruktur nach Anspruch 5, wobei jedes Kühlelement (200) einen Verbindungskanal (140) aufweist und ein oder mehrere Abführöffnungen (127) sich um gebildeten Verbindungskanal (140) herum erstrecken.

7. Die Kühlstruktur nach Anspruch 5 oder Anspruch 6, wobei jedes Kühlelement (200) in der Wärmeaufnahmefläche (115) rhombusförmig gebildet ist und in einem Zentralbereich einen rhombusförmigen Verbindungskanal (140) aufweist, der zwei gegenüberliegende Abführöffnungen (127) trennt.

8. Die Kühlstruktur nach Anspruch 7, wobei die rhombusförmigen Kühlelemente (200) zwei spitzwinklige Ecken und zwei stumpfwinklige Ecken aufweisen und die spitzwinkligen Ecken der Kühlelemente (200) mit den spitzwinkligen Ecken des Verbindungskanals (140) mit einer Trennwand (124) verbunden sind.

9. Die Kühlstruktur nach einem der vorhergehenden Ansprüche, wobei jede Kühlwanne (112) durch eine umlaufende Partitionswand (114) und einen Abschnitt der Wärmeaufnahmefläche (115) gebildet ist, die von einer benachbarten Kühlwanne (112) fluid getrennt ist.

10. Die Kühlstruktur nach einem der vorhergehenden Ansprüche, wobei jedes Kühlelement (200) der Kühlstruktur einen einzelnen Wärmetauscher bildet, und die Vielzahl der Kühlelemente (200) eine Parallelschaltung der einzelnen Wärmetauscher bildet.

11. Die Kühlstruktur nach einem der vorhergehenden Ansprüche, wobei in der Zuführebene (130) eine Vielzahl von pyramidenförmigen Stützelementen (134) gebildet sind, die eine vorbestimmte Kanalbreite (B) definieren und/oder das Kühlmedium (70) teilweise in die Verbindungskanäle (140) leiten, um eine vorbestimmte Menge an Kühlmedium (70) der Wärmeaufnahmeebene (110) zuzuführen.

12. Die Kühlstruktur nach einem der vorhergehenden Ansprüche, wobei die einzelnen Abführöffnungen (127) und/oder die einzelnen der Zuführöffnungen (137) verschiedene Querschnittsflächen senkrecht zur Flussrichtung des Kühlmediums (70) aufweisen oder in der Wärmeaufnahmeebene (110) Kühlstrukturen (116) ausgebildet sind, um die Wärmeaufnahmefläche (115) mit einem vorbestimmten Wärmeverteilungsprofil zu kühlen.

13. Ein Verfahren zum Herstellen einer Kühlstruktur nach Anspruch 1, wobei die Kühlstruktur über ein additives Herstellungsverfahren hergestellt wird.

14. Das Verfahren nach Anspruch 13, wobei jede Kühlelement (200) separat hergestellt wird und das Verfahren weiter ein Zusammensetzen der Kühlelemente (200) umfasst, um die Kühlstruktur flächenförmig zu bilden.

15. Computerlesbares Speichermedium mit darauf gespeicherten Anweisungen, die bei Ausführung in einer Datenverarbeitungseinheit einer additiven Fertigungsmaschine, die additive Fertigungsmaschine veranlassen, das Verfahren nach Anspruch 13 oder Anspruch 14 auszuführen.

## Geänderte Patentansprüche

### Geänderte Patentansprüche gemäss Regel 137(2) EPÜ.

1. Eine mehrschichtige Kühlstruktur zum Kühlen einer Baugruppe (50) mittels eines Kühlmediums (70), mit folgenden Merkmalen:
eine Wärmeaufnahmeebene (110) mit einer Wärmeaufnahmefläche (115) und einer darauf ausgebildeten Vielzahl von Kühlwannen (112), wobei die Wärmeaufnahmefläche (115) an die Baugruppe (50) koppelbar ist, um Wärme (Q) durch das Kühlmedium (70) in den Kühlwannen (112) aufzunehmen;
eine Wärmeabführebene (120), die einen Abführkanal (125) für das Kühlmedium (70) mit der aufgenommenen Wärme (Q) bildet und der Abführkanal (125) über eine Vielzahl von Abführöffnungen (127) mit der Wärmeaufnahmeebene (110) fluid in Verbindung steht;
eine Zuführebene (130), die einen Zuführkanal (135) für das Kühlmedium (70) bildet und eine Vielzahl von Zuführöffnungen (137) aufweist; und
eine Vielzahl von Verbindungskanälen (140), die jeweils eine Zuführöffnung (137) mit jeweils einer Kühlwanne (112) fluid verbinden,
wobei die Wärmeaufnahmeebene (110), die Wärmeabführebene (120) und die Zuführebene (130) schichtweise übereinander angeordnet sind,
**dadurch gekennzeichnet, dass**
in der Zuführebene (130) eine Vielzahl von pyramidenförmigen Stützelementen (134) gebildet sind, die eine vorbestimmte Kanalbreite (B) definieren, wobei
die Wärmeabführebene (120) zwischen der Wärmeaufnahmeebene (110) und der Zuführebene (130) angeordnet ist und die Vielzahl von Verbindungskanälen (140) sich durch die Wärmeabführebene (120) hindurch erstrecken.

2. Die Kühlstruktur nach Anspruch, wobei die Verbindungskanäle (140) senkrecht zu der Wärmeaufnahmefläche (115) oder abgeschrägt dazu ausgebildet sind.

3. Die Kühlstruktur nach einem der vorhergehenden Ansprüche, wobei eine Strömungsrichtung des Kühlmediums (70) in der Wärmeabführebene (120) und der Zuführebene (130) zumindest abschnittsweise parallel verläuft.

4. Die Kühlstruktur nach einem der vorhergehenden Ansprüche, wobei die Wärmeaufnahmeebene (110), die Wärmeabführebene (120) und die Zuführebene (130) durch eine periodische Aneinanderreihung einer Vielzahl von Kühlelementen (200) aufgebaut sind, sodass die Kühlstruktur eine regelmäßige flächige Kühlstruktur bildet, wobei jedes Kühlelement (200) zumindest eine der folgenden Komponente aufweist:
- eine Kühlwanne (112),
- eine Abführöffnung (127)
- einen Zuführöffnung (137),
- einen Verbindungskanal (140).

5. Die Kühlstruktur nach Anspruch 4, wobei jedes Kühlelement (200) einen Verbindungskanal (140) aufweist und ein oder mehrere Abführöffnungen (127) sich um gebildeten Verbindungskanal (140) herum erstrecken.

6. Die Kühlstruktur nach Anspruch 4 oder Anspruch 5, wobei jedes Kühlelement (200) in der Wärmeaufnahmefläche (115) rhombusförmig gebildet ist und in einem Zentralbereich einen rhombusförmigen Verbindungskanal (140) aufweist, der zwei gegenüberliegende Abführöffnungen (127) trennt.

7. Die Kühlstruktur nach Anspruch 6, wobei die rhombusförmigen Kühlelemente (200) zwei spitzwinklige Ecken und zwei stumpfwinklige Ecken aufweisen und die spitzwinkligen Ecken der Kühlelemente (200) mit den spitzwinkligen Ecken des Verbindungskanals (140) mit einer Trennwand (124) verbunden sind.

8. Die Kühlstruktur nach einem der vorhergehenden Ansprüche, wobei jede Kühlwanne (112) durch eine umlaufende Partitionswand (114) und einen Abschnitt der Wärmeaufnahmefläche (115) gebildet ist, die von einer benachbarten Kühlwanne (112) fluid getrennt ist.

9. Die Kühlstruktur nach Anspruch 1 bis Anspruch 9, wobei jedes Kühlelement (200) der Kühlstruktur einen einzelnen Wärmetauscher bildet, und die Vielzahl der Kühlelemente (200) eine Parallelschaltung der einzelnen Wärmetauscher bildet.

10. Die Kühlstruktur nach einem der vorhergehenden Ansprüche, wobei die Vielzahl von pyramidenförmigen Stützelementen (134) das Kühlmedium (70) teilweise in die Verbindungskanäle (140) leiten, um eine vorbestimmte Menge an Kühlmedium (70) der Wärmeaufnahmeebene (110) zuzuführen.

11. Die Kühlstruktur nach einem der vorhergehenden Ansprüche, wobei die einzelnen Abführöffnungen (127) und/oder die einzelnen der Zuführöffnungen (137) verschiedene Querschnittsflächen senkrecht zur Flussrichtung des Kühlmediums (70) aufweisen oder in der Wärmeaufnahmeebene (110) Kühlstrukturen (116) ausgebildet sind, um die Wärmeaufnahmefläche (115) mit einem vorbestimmten Wärmeverteilungsprofil zu kühlen.

12. Ein Verfahren zum Herstellen einer Kühlstruktur nach Anspruch 1, wobei die Kühlstruktur über ein additives Herstellungsverfahren hergestellt wird, und wobei jede Kühlelement (200) separat hergestellt wird und das Verfahren weiter ein Zusammensetzen der Kühlelemente (200) umfasst, um die Kühlstruktur flächenförmig zu bilden.

13. Computerlesbares Speichermedium mit darauf gespeicherten Anweisungen, die bei Ausführung in einer Datenverarbeitungseinheit einer additiven Fertigungsmaschine, die additive Fertigungsmaschine veranlassen, das Verfahren nach Anspruch 12 auszuführen.
